Europäisches Patentamt

European Patent Office

Office européen des brevets

(11) Publication number: **0 119 689**
A2

## EUROPEAN PATENT APPLICATION

(21) Application number: 84300404.5

(51) Int. Cl.³: **G 06 F 5/04**

(22) Date of filing: 24.01.84

(30) Priority: 22.02.83 CA 422142

(43) Date of publication of application: 26.09.84
Bulletin 84/39

(84) Designated Contracting States: AT DE FR GB NL SE

(71) Applicant: NORTHERN TELECOM LIMITED,
1600 Dorchester Boulevard West, Montreal Quebec
H3H 1R1 (CA)

(72) Inventor: Aczel, Andreas Laszlo, 8 Longwood Avenue,
Nepean Ontario, K2H 6G2 (CA)
Inventor: Watchorn, James Leslie, 71 Granton Avenue,
Nepean Ontario, K2G 1W9 (CA)
Inventor: Wong, Edmund Pea Fu, 1191 Plante Drive,
Ottawa Ontario, K1V 9E9 (CA)

(74) Representative: Crawford, Andrew Birkby et al, A.A.
THORNTON & CO. Northumberland House 303-306 High
Holborn, London WC1V 7LE (GB)

(54) Serial and parallel interface device.

(57) An interface device (110) for converting serial data to parallel data and vice-versa is disclosed. The interface device (110) is comprised of a plurality of storage elements (SE) electrically interconnected into an array (113) having an equal number of rows and columns. Each storage element comprises a storage device (116) and two switching devices (117, 118) for selectively applying data from one of two inputs (A, E) of the storage element (SE) to the storage device (116). As a result, data can be shifted through the array either along rows or along columns. The data, for a serial to parallel conversion, is shifted either along rows or columns of the array and is removed from the array, either one parallel word per time, one bit per each column of the array, or one parallel word per time, one bit per each row of the array. For a parallel to serial conversion, parallel data is applied sequentially to the array, either one bit per row or one bit per column of the array. This data is then removed from the array in a serial fashion either one bit stream per each column of the array or one bit stream per each row of the array.

ACTORUM AG

0119689

This invention relates generally to the field of data manipulation, and more particularly to the conversion of serial data to parallel data and of parallel data to serial data.

In the handling of digital information, it is often necessary to convert serial data into parallel data, and vice-versa. This has resulted in the development of various forms of digital converters. For instance, a plurality of serial data streams can be fed concurrently into corresponding shift registers and thence fed out in parallel into a multiplex unit which sequentially selects each of the parallel outputs in turn to provide a train of parallel digital outputs.

Conversely, parallel information may be converted into a plurality of serial information streams by selectively transferring the information into a number of shift registers. The information is then fed out from each of the shift registers in serial form.

The use of a matrix of shift registers for performing these chores has also been proposed. United States patent 3,778,773 dated December 11, 1973 by D.F. Hood describes a matrix of shift registers under the control of a plurality of gates for manipulating data information.

United States patent 2,957,163 dated October 18, 1960 by R.D. Kodis depicts another scheme for transferring serial data to parallel data and vice-versa.

Various other circuits for performing data transformation of this general type include the following. United States patent 4,302,686 dated November 24, 1981 by R.D. Baertsch et al and United States patent 4,231,052 dated October 28, 1980 by D.J. Day et al.

In accordance with the present invention, a reconfigurable array of storage elements provides for the continuous conversion of serial data into parallel data. The same array also provides for the continuous conversion of parallel data into serial data.

In somewhat more detail, the present invention is an interface device for performing conversion between serial and parallel binary data, the interface device comprising: a plurality of storage elements connected electrically into an array having n rows and n columns, n being a positive integer, $n \geq 2$, wherein data is directed through the array in a direction alternately along the rows and along the columns, and wherein data is available to be removed from the array in a direction alternately along the rows and along the columns such that binary data applied to the array in a serial fashion can be removed in a parallel fashion and binary data applied to the array in a parallel fashion can be removed in a serial fashion.

Stated in yet other terms, the present invention is an interface device for performing conversion between serial and parallel binary data, the interface device comprising: a plurality of storage elements connected electrically into an array having n rows and n columns, n being a positive integer, $n \geq 2$; each storage element comprising a storage means and a switching means for selectively applying data from one of two input terminals to the data input of the storage means such that data can be selectively shifted through the array either along the rows or along the columns.

Stated in still other terms, the present invention is an interface device for performing conversion between serial and parallel binary data, the interface device comprising: a plurality of storage elements, each storage element having two data input terminals and at least one data output terminal and comprising a storage means and a controllable switching means for selectively applying data from one of the two data input terminals of the storage element to the data input of the storage means; the storage elements connected electrically into an array having equal numbers of rows and columns, and wherein data can be applied to the array in one of the following manners:

a) a plurality of serial data streams are applied simultaneously to the array, not more than one serial data stream per row of the array;

b) a plurality of serial data streams are applied simultaneously to the array, not more than one serial data stream per column of the array;

c) parallel data is applied sequentially to the array, one word at a time, not more than one bit per row of the array;

d) parallel data is applied sequentially to the array, one word at a time, not more than one bit per column of the array;

and wherein data is removed from the array in one of the following manners, respectively:

a) data is removed from the array, one parallel word per time, one bit per each column of the array;

b) data is removed from the array, one parallel word per time, one bit per each row of the array;

c) data is removed from the array, in a serial fashion, one bit stream per each column of the array, and

d) data is removed from the array, in a serial fashion, one bit stream per each row of the array;

whereby binary data applied to the array in a serial fashion can be removed in a parallel fashion and binary data applied to the array in a parallel fashion can be removed in a serial fashion.

The invention will now be described in more detail with reference to the accompanying drawings, wherein like parts in each of the several figures are identified by the same reference character, and wherein:

Figure 1 is a simplified block diagram of the present invention;

Figure 2 is a simplified schematic diagram of one of the storage elements from Figure 1;

Figure 3 is a simplified schematic diagram depicting the interconnection of four of the storage elements of Figure 2; and

Figure 4 depicts two timing waveforms.

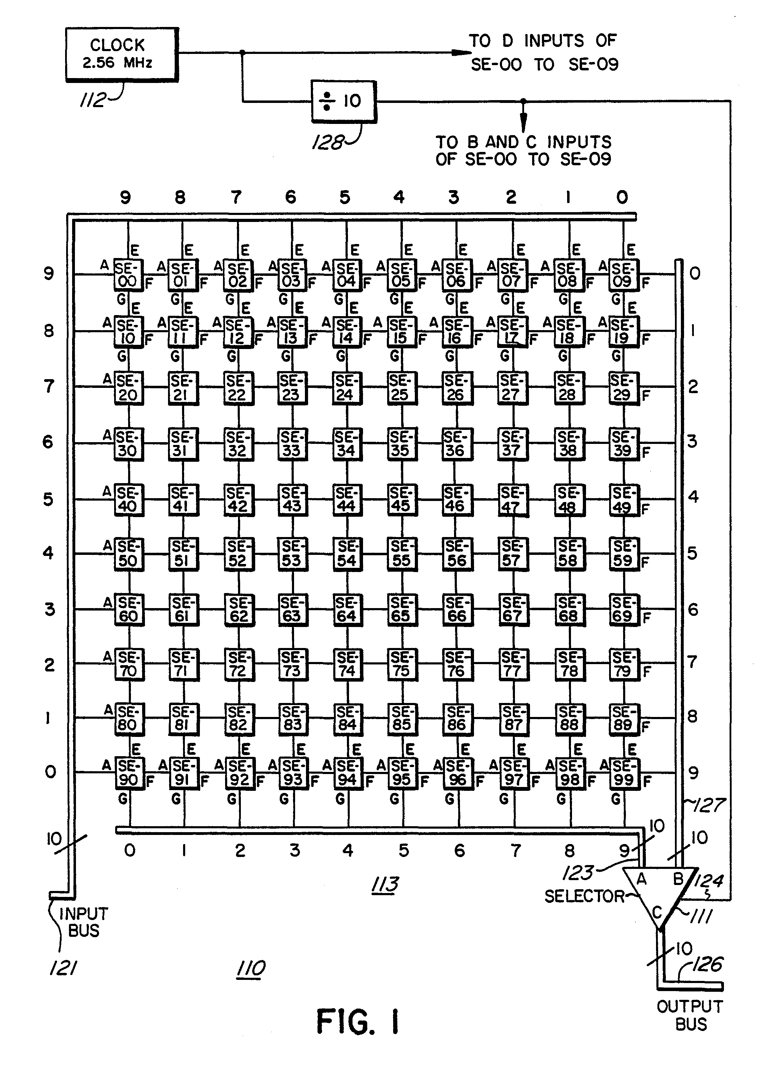

Figure 1 depicts interface device 110 of the present invention (sometimes referred to as a formatter) along with an output selector device 111, a clock 112, and a divide-by-ten circuit 128.

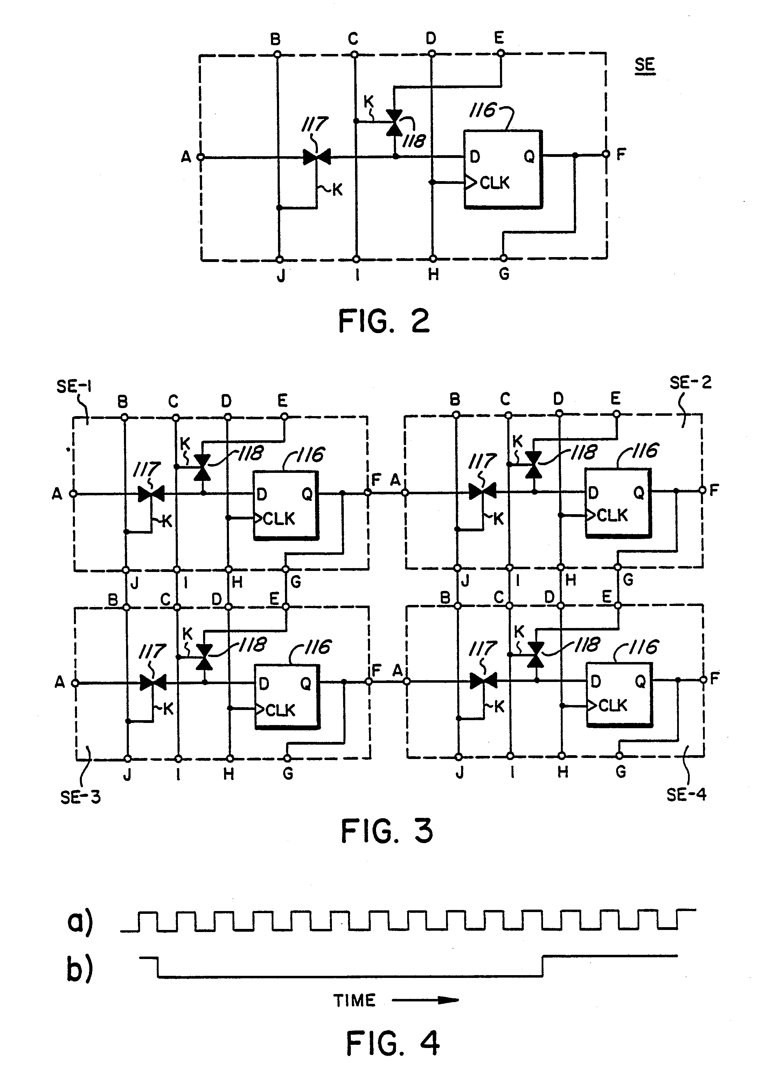

Interface device 110 is comprised, in the exemplary embodiment of Figure 1, of one hundred storage elements, referenced as SE-00 to SE-99, inclusive, and referred to collectively as storage elements SE. Each storage element SE is identical to every other storage element SE and one is depicted in more detail in Figure 2.

Before Figure 1 is described in any more detail it may be advantageous to study Figure 2 in more detail. As depicted in Figure 2, each storage element SE comprises a D-type flip-flop 116. The D input of flip-flop 116 can receive an input signal from either input terminal A or E, of storage element SE, via gate 117 or 118 respectively. Gates 117 and 118 are transistors which can be biased in their off or non-conducting state or in their on or conducting state. The appropriate control signal on terminal B is applied, via control electrode K, to gate 117. When gate 117 turns on, signals from terminal A are applied to the D input of flip-flop 116. Similarly, the appropriate control signal on terminal C is applied, via control electrode K, to gate 118. When gate 118 turns on, signals from terminal E are applied to the D input of flip-flop 116. As will be explained later, in greater detail, gates 117 and 118 are controlled in such a fashion that they are not both conducting at the same time.

It should also be noted that the signals that are applied to input terminals B and C are the same signals appearing at output terminals J and I, respectively. A clock signal, applied to input terminal D (of storage element SE), is in turn applied to clock input terminal CLK of flip-flop 116 and to output terminal H. The Q output of flip-flop 116 is connected to both output terminals F and G.

Figure 3 depicts an exemplary interconnection of four storage elements referenced as SE-1, SE-2, SE-3, and SE-4 (all identical to the storage element SE of Figure 2). To begin with, assume that the input data is being applied from the left in Figure 3 (i.e. being applied to terminals A of storage elements SE-1 and SE-3). Consequently, the control signal on input terminals B of both storage elements SE-1 and SE-2 is such that gates 117 of storage elements SE-1, SE-2, SE-3, and SE-4 are conducting; also, the control signal on input terminals C of both storage elements SE-1 and SE-2 is such that gates 118 of storage elements SE-1, SE-2, SE-3 and SE-4 are non-conducting. As a result, data flows from input terminal A of storage element SE-1, through gate 117 of SE-1, to the D input of flip-flop 116 of storage element SE-1. The data is clocked into flip-flop 116 by a clock signal on input terminal D (of SE-1).  It is then clocked out of the Q output of flip-flop 116 and applied to both the F and G output terminals of storage element SE-1.  Since gates 118 are turned off (non-conducting), the signal on the G output terminal is blocked.  The signal on the F output terminal of SE-1 is applied to the A input terminal of storage element SE-2 where it is passed by gate 117 (of SE-2) and applied to the D input of flip-flop 116 (of SE-2).

A similar route occurs for data applied to the A input terminal of storage element SE-3.  The data is routed through gate 117 (of SE-3) to flip-flop 116 (of SE-3) to the F output terminal (of SE-3), to the A input terminal of storage element SE-4, through gate 117 (of SE-4) to the D-input of flip-flop 116 (of SE-4), from the Q output of flip-flop 116 (of SE-4) to the F and G outputs (of SE-4).  Note that the timing of the clock signal on input terminals D is such that the combination of SE-1 and SE-2 act as a shift register, shifting to the right; likewise for the combination of SE-3 and SE-4.

Now assume that the input data is being applied from the top in Figure 3 (i.e. being applied to terminals E of storage elements SE-1 and SE-2).  Consequently, the control signal on input terminals C of both storage elements SE-1 and SE-2 is such that gates 118 of storage elements SE-1, SE-2, SE-3, and SE-4 are conducting; also, the control signal on input terminals B of both storage elements SE-1 and SE-2 is such that gates 117 of storage elements SE-1, SE-2, SE-3, and SE-4 are non-conducting.  As a result, data flows from input terminal E of storage element SE-1, through gate 118 of SE-1, to the D input of flip-flop 116 of storage element SE-1.  The data is clocked into flip-flop 116 by a clock signal on input terminal D (of SE-1).  It is then clocked out of the Q output of flip-flop 116 and applied to both the F and G output terminals of storage element SE-1. Since gates 117 are turned off (non-conducting), the signal on the F output terminal is blocked. The signal on the G output terminal of SE-1 is applied to the E input terminal of storage element SE-3 where it is passed by gate 118 (of SE-3) and applied to the D input of flip-flop 116 (of SE-3).

A similar route occurs for data applied to the E input terminal of storage element SE-2. The data is routed through gate 118 (of SE-2) to flip-flop 116 (of SE-2) to the G output terminal (of SE-2), to the E input terminal of storage element SE-4, through gate 118 (of SE-4) to the D input of flip-flop 116 (of SE-4), from the Q output of flip-flop 116 (of SE-4) to the F and G outputs (of SE-4). Note that the timing of the clock signal on input terminals D (of SE-1 and SE-2) is such that the combination of SE-1 and SE-3 act as a shift register, shifting from top to bottom; likewise for the combination of SE-2 and SE-4.

Now, let's return to Figure 1. Figure 1 depicts, in simplified fashion, the interconnection of one hundred storage elements referenced from SE-00 to SE-99; each such storage element is identical to the one depicted in Figure 2 and they are referred to collectively as storage elements SE. The storage elements SE-00 to SE-99 of Figure 3 are interconnected into an array 113 in the same fashion as are the storage elements SE-1 to SE-4 of Figure 3. In order to keep the Figure 3 embodiment from becoming too unwieldly, only the data signal paths of the storage elements in Figure 1 have been depicted (i.e. those paths associated with terminals A, E, F, and G of each storage element SE).

As an example of the operation of the interface device 110 of Figure 1, assume that ten serial binary data streams are applied to input bus 121. One binary data stream is applied to input terminal A of SE-00 and this same binary data stream is applied to input terminal E of SE-00. A second binary data stream is applied both to input terminal A of SE-10 and to input terminal E of SE-01. A third binary data stream is applied both to input terminal A of SE-20 and to input terminal E of SE-02. Similarly, as depicted in Figure 1, the remaining seven binary data streams are applied to the input terminals of storage elements SE-30, SE-40, SE-50, SE-60, SE-70, SE-80 and SE-90 and SE-03 to SE-09, inclusive in a similar fashion.

As a result of this interconnection, the serial data on bus 121 can be shifted either along rows of array 113 or along columns of array 113, depending upon the states of the gates 117 and 118. For example, if all the gates 117 of the storage elements SE are conducting and all the gates 118 of the storage elements SE are non-conducting, then data is accepted only by the A inputs of storage elements SE-00, SE-10, SE-20, SE-30, SE-40, SE-50, SE-60, SE-70, SE-80, and SE-90 of array 113 and the data is shifted along rows of the array 113 (i.e. from left to right).

On the other hand, if all the gates 118 of the storage elements SE are conducting and all the gates 117 of the storage elements SE are non-conducting, then data is accepted only by the E inputs of storage elements SE-00 to SE-09, inclusive, of array 113 and the data is shifted along columns of the array 113 (i.e. from top to bottom).

Now let's describe an exemplary operation of interface device 110. For the purposes of this document, a byte will be considered to consist of a given number of bits and a word will be considered to consist of a given number of bytes. Assume that each binary word contains ten bits and assume that a word consists of one byte in this example. Assume that the data from bus 121 is initially being applied along the rows of array 113 (i.e. all gates 117 are conducting and all gates 118 are non-conducting). The first bit of one serial data stream is applied to storage element SE-00 (via terminal A). The first bit of a second serial data stream is applied to storage element SE-10 (via terminal A). Similarly, the first bits of the third through tenth serial data streams are applied to storage elements SE-20, SE-30, SE-40, SE-50, SE-60, SE-70, SE-80, and SE-90, respectively. This loading of this first column of array 113 happens on the first clock pulse (applied to terminals D of storage elements SE-00 to SE-09 inclusive).

At the second clock pulse, the contents of the first (leftmost) column of array 113 are shifted to the second column of array 113 (i.e. one column to the right). At the same time, the second bits of the ten serial data streams are applied to the storage elements SE of the first column of array 113 (in an analagous fashion to the first bits). This procedure continues for a total of ten clock pulses, until all ten bits of each of the serial words are stored in array 113. At the end of this time, the row of array 113 consisting of storage elements SE-00 to SE-09 contains one complete word, the row consisting of storage elements SE-10 to SE-19 contains another complete word, etc. In short, the data from bus 121 has traversed rows of array 113, from left to right.

At this point in time, the mode of operation of gates 117 and 118 changes such that all gates 117 become non-conducting and all gates 118 become conducting. As a result, the serial data on input bus 121 now begins to traverse columns of array 113, from top to bottom. In other terms, a first word is shifted down the first column of array 113, a second word is shifted down the second column of array 113, etc. As the first bits of the second words are applied to the first row of array 113 (i.e. to storage elements SE-00 to SE-09 inclusive) the data stored in array 113 is all shifted down by one position and the word contained in the bottom row of array 113 (i.e. storage elements SE-90 to SE-99, inclusive) is outputted onto bus 123 (ten bits in parallel).

As the second bits are applied to the first row of array 113, the bits already stored in array 113 are, once again, all shifted down one position. As a result, the new word now contained in the last row of array 113 is outputted onto bus 123. This process continues until all ten bits of the serial words being applied to the top row of array 113 are all stored in the array.

During this time period, selector 111 has been controlled (by lead 124) to apply the signals appearing on its A inputs to its C outputs and consequently a series of ten bit parallel words is produced on output bus 126.

Once array 113 has received ten serial bits (i.e. a complete word) applied to the top row, gates 117 and 118 are once again changed such that gates 117 are conducting and gates 118 are non-conducting. As a result, data once again traverses array 113 along rows. The signal on lead 124 now causes selector 111 to apply the signals appearing on its B inputs to its C outputs and consequently a series of ten bit parallel words is produced on output bus 126.

As each new bit is clocked into each row of array 113, the data in array 113 moves to the right. With the first shift, the ten bits (i.e. word) contained in the rightmost column is outputted onto bus 127 as a ten bit parallel word. This data is applied to input B of selector 111 which in turn connects it (under control of lead 124) to output bus 126.

In short, serial data applied to input bus 121 has been converted to parallel data on output bus 126.

Interface device 110 can also convert parallel data applied to its input bus 121 into serial data on its output bus 126. In this mode of operation, a ten-bit word is applied to input bus 121 and (with gates 117 conducting and gates 118 non-conducting) then applied to the leftmost column of array 113. As additional words are applied to input bus 121 array 113 becomes filled, one column at a time, until all ten columns are filled (i.e. ten words have been received).

At this point in time gates 117 and 118 are changed such that gates 117 are non-conducting and gates 118 are conducting. As a result, each word on input bus 121 is now applied to the top row of array 113 and the array now shifts from top to bottom. As the first word in this new direction is being received by array 113, the bits contained in the bottom row of array 113 are outputted on to bus 123. As each column contained one word, this results in one bit from each word being applied to bus 123 and as the shifting continues, we of course get serial data. As before, selector 111 connects the signals received on its A inputs to its C outputs (under control from lead 124).

After ten words have been applied to the top row of array 113, gates 117 and 118 are again changed. Gates 117 become conducting and gates 118 become non-conducting. As a result, the words are applied to the leftmost column of array 113 and are shifted to the right. The serial data is now outputted onto bus 127. Selector 111, under the control of lead 124, now connects its B inputs to its C outputs and consequently bus 127 is connected to output bus 126.

Note that in the embodiment preferred by the inventors, array 113 is manufactured as an integrated circuit.

Clock 112 produces an approximately square wave output having a frequency of 2.56 MHz. This clock signal is applied to the D inputs of storage elements SE-00 to SE-09, inclusive. A divide-by-ten circuit 128 is responsive to the output of clock 112. The output of circuit 128 is applied to lead 124 to control selector 111, and is also applied to the B and C inputs of storage elements SE-00 to SE-09 inclusive. Note that when the output of divide-by-ten circuit 128 goes high, gates 117 are conducting, gates 118 are non-conducting and selector 111 has its B inputs connected to its C outputs. When the output of divide-by-ten circuit 128 goes low, gates 117 are non-conducting, gates 118 are conducting and selector 111 has its A inputs connected to its C outputs. The outputs of clock 112 and circuit 128 are depicted in Figures 4a and 4b, respectively.

It should also be noted that the embodiment of Figure 1 can also be used in a subset mode. That is, it can also be used for words of less than ten bits.

For example, suppose one wanted to transform six serial data streams (each comprised of words of six bits each) into parallel outputs, each of six bits. The data is applied to input bus 121 such that it is tapped off bus 121 from leads 0 to 5 inclusive. In other words, it is applied to terminals A of storage elements SE-90, SE-80, SE-70, SE-60, SE-50, and SE-40 and to terminals E of storage elements SE-09, SE-08, SE-07, SE-06, SE-05, and SE-04.

The data is received on leads 0 to 5 inclusive of bus 123 and leads 0 to 5 inclusive of bus 127, depending upon whether the data in array 113 is being shifted horizontally or vertically.

Note also that circuit 128 must be changed to account for the number of bits in the words in question. For the example just given, where there are six bits in each words, circuit 128 must become a divide-by-six circuit (in lieu of a divide-by-ten circuit). An analogous arrangement can be made for parallel to serial conversion in the subset mode. Note that in the subset mode the number of serial data streams involved cannot exceed the number of bits per word (i.e. if each word is comprised of eight bits, then no more than eight serial data streams can be handled by array 113).

1. An interface device (110) for performing conversion between serial and parallel binary data, said interface device characterized by: .

a plurality of storage elements (SE) connected electrically into an array (113) having n rows and n columns, n being a positive integer, $n \geq 2$, wherein data is directed through said array in a direction alternately along said rows and along said columns, and wherein data is available to be removed from said array in a direction alternately along said rows and along said columns such that binary data applied to said array in a serial fashion can be removed in a parallel fashion and binary data applied to said array in a parallel fashion can be removed in a serial fashion.

2. The interface device of claim 1 wherein each said storage element can store one bit of data.

3. The interface device of claim 1 wherein said binary data is in the form of words and each said word is n bits long or a submultiple of n.

4. The interface device of claim 3 wherein said data changes direction through said array after the reception of every n bits of data.

5. The interface device of claim 4 further including a selection means (111) for selecting, as its output, either the data being shifted along the rows, or the data being shifted along the columns.

6. The interface device of claim 1 wherein said binary data is in the form of words and said words are less than n bits long, and the direction through the array is altered at the rate of once every word.

7. An interface device (110) for performing conversion between serial and parallal binary data, said interface device characterized by:

a plurality of storage elements (SE) connected electrically into an array (113) having n rows and n columns, n being a postive integer, $n \geq 2$;

each said storage element (SE) comprising a storage means (116) and a switching means (117, 118) for selectively applying data from one of two input terminals (A, E) to the data input of said storage means such that data can be selectively shifted through said array either along said rows or along said columns.

8. The interface device of claim 7 wherein said switching means (117, 118) alters the direction of the data through the array.

9. The interface device of claim 8 further including a selection means (111) for selecting, as its output, either the data being shifted along the rows, or the data being shifted along the columns.

10. The interface device of claim 9 wherein n equals ten.

11. The interface device of claim 9 wherein n equals eight.

12. The interface device of claim 7 wherein said binary data is in the form of words and said words are less than n bits long, and the direction through the array is altered at the rate of once every word.

13. An interface device (110) for performing conversion between serial and parallel binary data, said interface device characterized by:

a plurality of storage elements (SE), each said storage element having two data input terminals (A, E) and at least one data output terminal (F, G) and comprising a storage means (116) and a controllable switching means (117, 118) for selectively applying data from one of the two data input terminals (A, E) of said storage element (SE) to the data input (D) of said storage means (116);

said storage elements (SE) connected electrically into an array (113) having equal numbers of rows and columns, and wherein data can be applied to said array in one of the following manners:

a) a plurality of serial data streams are applied simultaneously to the array, not more than one said serial data stream per row of the array;

b) a plurality of serial data streams are applied simultaneously to the array, not more than one said serial data stream per column of the array;

c) parallel data is applied sequentially to the array, one word at a time, not more than one bit per row of the array;

d) parallel data is applied sequentially to the array, one word at a time, not more than one bit per column of the array;

and wherein data is removed from the array in one of the following manners, respectively:

a) data is removed from the array, one parallel word per time, one bit per each column of the array;

b) data is removed from the array, one parallel word per time, one bit per each row of the array;

c) data is removed from the array, in a serial fashion, one bit stream per each column of said array; and

d) data is removed from the array, in a serial fashion, one bit stream per each row of said array;

whereby binary data applied to said array in a serial fashion can be removed in a parallel fashion and binary data applied to said array in a parallel fashion can be removed in a serial fashion.

14. The interface device of claim 13 wherein there are ten rows and ten columns, and wherein each said word consists of ten bits.

0119689

FIG. 1

FIG. 2

FIG. 3

FIG. 4